# EUROPEAN PATENT APPLICATION

(11) **EP 4 080 124 A1**
(43) Date of publication of application: **26.10.2022**
(21) Application number: 21169955.8
(22) Date of filing: 22.04.2021
(51) Int. Cl.: F24D 3/10, H01F 27/26

(54) **EXPANSION VESSEL FOR A COOLING SYSTEM**

(71) Applicant: Hitachi Energy Switzerland AG, 5400 Baden (CH)
(72) Inventor: STRÖMBERG, Andreas, 247 91 S Sandby (SE)
(74) Representative: Valea AB

(57) **Abstract**

The present invention relates to an expansion vessel (10) for a cooling system (1) using a cooling medium comprising water, the expansion vessel (10) forming a chamber (100), which, during normal operation of said cooling system (1), is open to atmospheric air ambient of said chamber and comprises
- a cooling medium volume (200) filling said chamber (100) up to a cooling medium surface (201);
- a fluid volume (400) of a fluid having a density between the density of the cooling medium and the density of the atmospheric air;
said fluid volume (400) filling said chamber (100) from said cooling medium surface (201) to a fluid volume upper surface (401), wherein said fluid volume (400) is selected such that, for each location of the cooling medium surface (201) between a minimum cooling medium level (201min) and a maximum cooling medium level (201max), a thickness of said fluid volume (400) from said cooling medium surface (201) to said fluid volume upper surface (401) is sufficient to hinder said atmospheric air from being dissolved in the cooling medium via said fluid volume (400); and
- a non-zero air volume (300) of atmospheric air.

## Description

### TECHNICAL FIELD

The present disclosure relates to an expansion vessel for a cooling system using a cooling medium comprising water, the expansion vessel being open to ambient air. The disclosure also relates to a cooling system comprising an expansion vessel, to a method for hindering corrosion in an expansion vessel, and to a method for controlling a fluid layer in an expansion vessel.

### BACKGROUND OF THE INVENTION

Cooling systems utilizing a liquid cooling medium comprising water are widely used, for example in power transmission applications and for industries. In many applications, pure water cooling systems are preferred, i.e. wherein the liquid cooling medium comprises water possibly with an additive such as an anti-freeze agent, but no additional cooling agent but the water per se.

Pure water cooling systems are used in applications such as for example HVDC (High Voltage Direct Current), SVC (Static Var Compensator), rectifiers and converters, metallurgic processing, research and medical applications, non-electrical environments.

Cooling systems conventionally comprise one or more expansion vessels to take up the expansion and reduction of the cooling medium caused e.g. by temperature variations in the cooling system. Expansion vessels for cooling systems are thus designed to enable taking up a varying volume of cooling medium.

Closed expansion vessels, i.e. expansion vessels that are closed to ambient air and atmospheric pressure, are generally pressurized vessels. As such, they are subject to stringent regulatory requirements which for example involve regular inspection of the vessels. Also, the need for pressurizing the closed expansion vessels requires additional space for the pressurizing arrangement in the cooling system, and further raises particular concerns when it comes to positioning of the closed expansion vessel in the cooling system.

Open expansion vessels are vessels which are open to ambient air, and thus operates at atmospheric pressure. Accordingly, open expansion vessels do not require regular inspection to fulfil safety requirements such as pressurized vessels. Also, open expansion vessels have the benefits of simple construction and operation, and hence presents advantages in terms of space and positioning requirements in the cooling system.

Accordingly, it is desired to utilize open expansion vessels for cooling systems using a cooling medium comprising water.

However, one drawback of open expansion vessels in cooling systems using a cooling medium comprising water, such as in pure water cooling systems, is that since the vessels are open to ambient air, the oxygen in the air may dissolve in the water. The dissolved oxygen creates ions which poses a problem in view of the cooling medium becoming conductive and which also promotes corrosion in the vessels. Due to these drawbacks, cooling systems utilizing a cooling medium comprising water have conventionally been provided with closed expansion vessels.

The object of the invention is to provide an expansion vessel for a cooling system using a cooling medium comprising water, and which is open to ambient air, while providing an improvement in relation to existing expansion vessels.

### SUMMARY OF THE INVENTION

The above-mentioned object is achieved in a first aspect by an expansion vessel for a cooling system using a cooling medium comprising water, the expansion vessel forming a chamber having an extension in a vertical direction, and, during normal operation of the cooling system, the chamber is open to atmospheric air ambient of the chamber and comprises
- a cooling medium volume of the cooling medium, the cooling medium volume filling the chamber up to a cooling medium surface which is located between a minimum cooling medium level and a maximum cooling medium level in the chamber;
- a fluid volume of a fluid having a density between the density of the cooling medium and the density of atmospheric air;
   the fluid volume filling the chamber from the cooling medium surface to a fluid volume upper surface, wherein the fluid volume is selected such that, for each location of the cooling medium surface between the minimum cooling medium level and the maximum cooling medium level, a thickness of the fluid volume from the cooling medium surface to the fluid volume upper surface is sufficient to hinder the atmospheric air from being dissolved in the cooling medium via the fluid volume; and
- a non-zero air volume of atmospheric air, the air volume filling the remainder of the chamber vertically above the fluid volume upper surface.

The expansion vessel comprises a chamber being open to atmospheric air ambient of the chamber. That the chamber is open to atmospheric air means that exchange of atmospheric air between the inside of the chamber and the ambient air is enabled to hold the interior of the chamber at atmospheric pressure. As such, devices such as air filters or vents may be arranged for the passage of the atmospheric air into the chamber.

The chamber of the expansion vessel, when in use, comprises a cooling medium volume whose size differs depending on the present cooling medium expansion need in the cooling system. The cooling medium volume will fill the chamber up to a cooling medium surface, meaning that the vertical location of the cooling medium surface in the vessel will vary depending on the size of the present cooling medium in the chamber. During normal operation of the expansion vessel, the location of the cooling medium surface may vary between a minimum cooling medium level and a maximum cooling medium level in the chamber. Accordingly, the chamber of the cooling vessel may be adapted to the cooling system such that an expansion volume of the cooling medium corresponds to the volume of the chamber between the minimum cooling medium level and the maximum cooling medium level.

The expansion vessel, when in use, further comprises a fluid volume. The fluid volume is of a fluid having a density between the density of the cooling medium and the atmospheric air. By virtue of its density, the fluid volume will fill the chamber from the cooling medium surface to a fluid volume upper surface. Thus, the fluid volume contacts the cooling medium surface, i.e. the fluid volume rests immediately above the cooling medium volume.

During normal operation of the expansion vessel, the fluid volume is constant. Accordingly, the variations of the cooling medium volume causing the vertical location of the cooling medium surface to vary, will cause the fluid volume to move in vertical directions in the chamber.

Since the expansion vessel is open to ambient air at atmospheric pressure, the chamber, when in use, further comprises a non-zero air volume of atmospheric air, the air volume filling the remainder of the chamber vertically above the fluid volume upper surface.

Again, by virtue of the density of the fluid volume in relation to the ambient air, the air volume will fill the remainder of the chamber from the fluid volume upper surface. Thus, the air volume contacts the fluid volume upper surface, i.e. the air volume rests immediately above the fluid volume.

During normal operation of the expansion vessel, the size of the non-zero air volume may vary so as to account for any variations in the size of the cooling medium volume in the chamber.

As explained in the above, the fluid volume will be located between the cooling medium volume and the air volume in the chamber. Accordingly, the fluid volume will form a layer between the cooling medium and the air volume.

The fluid volume is selected such that, for each location of the cooling medium surface between the minimum cooling medium level and maximum cooling medium level, a thickness of the fluid volume from the cooling medium surface to the fluid volume upper surface is sufficient to hinder the atmospheric air from being dissolved in the cooling medium via the fluid volume.

Hence, the fluid volume hinders the atmospheric air from being dissolved in the cooling medium, and the drawbacks associated therewith e.g. relating to conductivity and corrosion may be avoided.

For determining the thickness of the fluid volume at a location of the cooling medium surface in the chamber it is sufficient to theoretically calculate the location of the fluid volume upper surface from the size of the fluid volume introduced in the vessel.

Accordingly, it is not necessary to practically determine the present location of a fluid volume upper surface in the vessel.

It will be understood, that when the chamber has a constant area in a plane perpendicular to the vertical direction between the minimum cooling medium level and the maximum cooling level, the thickness of the fluid volume will be constant during normal operation of the vessel.

However, should the chamber have a varying area in a plane perpendicular to the vertical direction, between the minimum cooling medium level and the maximum cooling medium level, the thickness of the constant fluid volume will vary between different vertical locations of the cooling medium surface. In this case, it may be sufficient to determine that the thickness of the fluid volume at the largest area of the chamber, perpendicular to the vertical direction, and between the minimum cooling medium level and the maximum cooling medium level, is sufficient to hinder the atmospheric air from being dissolved in the cooling medium.

To determine the required thickness of a fluid volume, the properties of the fluid may be studied. For example, if using a gas having a relatively high density, the required thickness of the fluid volume may be less than if using a gas having a relatively low density. Also, the size and shape of the vessel may have an impact on the required thickness of the gas layer. Generally, a smaller vessel may require a smaller thickness than a larger vessel.

Hence, in accordance with the present disclosure, an open expansion vessel for a cooling system utilizing a cooling medium comprising water is proposed which expansion vessel may operate at atmospheric pressure while avoiding the problems associated with corrosion.

Optionally, the fluid is a fluid being insoluble in the cooling medium. Thus, the fluid may be a fluid being insoluble in water.

Optionally, the fluid may be soluble in the cooling medium without forming ions. When the fluid is soluble in the cooling medium without forming ions, any risk of the fluid ions causing the cooling medium to become conductive or causing corrosion may be avoided. Thus, the fluid may be a fluid soluble in water without forming ions.

Optionally, the fluid is an inert fluid.

Optionally, the fluid is a gas.

Optionally, the fluid is a noble gas. For example, the gas is argon, xenon or krypton.

When referring to states of matter such as gas or liquid herein, it is referred to the state of the matter at temperatures relevant for the cooling system and at atmospheric pressure. Also, when referring to the density of the gas as compared to the density of atmospheric air and to the density of the cooling medium, the comparison should be made at temperatures relevant for the cooling system and at atmospheric pressure. The density of the gas should be less than the density of the cooling liquid and higher than that of atmospheric air at the same temperature.

The cooling medium comprising water will generally be a liquid.

Optionally, the fluid volume is selected such that the thickness of the fluid volume, for each location of the cooling medium surface in the chamber is at least 2 cm, preferably at least 3 cm, most preferred at least 5 cm. These values have been found to be suitable in particular for noble gases such as argon.

Although generally a greater thickness of the fluid volume will ensure that the fluid volume hinders the air from being dissolved in the cooling medium, it may still be desired to restrict the fluid volume so as to avoid unnecessary consumption of fluid and/or space for the expansion vessel. As outlined in the above, the chamber of the expansion vessel will, during normal operation thereof, comprise a non-zero volume of atmospheric air. This means that the thickness of the fluid volume is restricted by the requirement of the air volume in the expansion vessel, and that the expansion vessel proposed herein may avoid overconsumption of fluid, such as an initial fluid volume which will nevertheless be pushed out of the chamber if the cooling medium volume reaches e.g. the maximum cooling medium level.

Optionally, the expansion vessel according to any one of the preceding claims, wherein the fluid volume is selected such that the thickness of the fluid volume, for each location of the cooling medium surface in the chamber is less than 50 cm, preferably less than 15 cm, most preferred less than 10 cm.

Optionally, the cooling medium is tap water or deionized water. The tap water or the deionized water may comprise an anti-freeze agent. In this case, the cooling system may advantageously be a pure water system.

Optionally the cooling medium comprises at least 30 volume% of water, preferably at least 40 volume% of water.

Optionally, the chamber comprises at least one air conduit for inlet and/or outlet of air at atmospheric pressure. For example, the chamber may comprise one single air conduit for inlet and outlet of air. In another example, the chamber may comprise one air conduit for inlet of air and another air conduit for outlet of air.

Optionally, the air conduit may comprise a filter for intake air. Optionally, the air conduit may comprise a valve, e.g. dual direction valve.

Optionally, the air conduit may be arranged in a vertically upper portion of the chamber, for example at an uppermost portion of the chamber.

Optionally, the chamber comprises at least one cooling medium conduit for inlet and/or outlet of cooling medium.

For example, the chamber may comprise one single cooling medium conduit for inlet and outlet of cooling medium.

In another example, the chamber may comprise one cooling medium conduit for inlet of cooling medium and one cooling medium conduit for outlet of cooling medium.

Optionally, the cooling medium conduit may be arranged in a vertically lower portion of the chamber.

Optionally, the cooling medium conduit may be arranged vertically below the location at which the chamber is open to ambient air, for example vertically below an air conduit.

With "vertically" or "vertical" as used herein is meant a reference to a vertical direction only. Hence, items being located vertically below one another are items located in different horizontal planes, which items need not be aligned.

Optionally, the chamber comprises a fluid conduit for inlet/outlet of the fluid. Such a fluid conduit may be used for replenishing the chamber with the fluid volume.

For example, a fluid conduit for the fluid may be arranged vertically above any cooling medium conduit. For example, a fluid conduit for the fluid may be arranged vertically below the air conduit.

In another alternative, the fluid volume may be replenished via the intake of atmospheric air to the chamber, e.g. via an air conduit.

Optionally, the expansion vessel comprises a cooling medium level measuring arrangement for determining the vertical location of the cooling medium surface in the chamber.

During normal operation of the vessel, the cooling medium surface may vary between the minimum cooling medium level and the maximum cooling medium level in the chamber. Hence, during normal operation of the vessel, the fluid volume will remain constant in the chamber.

However, a fluid overflow level in the chamber may be defined as the vertical level in the chamber above which the volume of the chamber is equal to the fluid volume.

Optionally, the cooling medium level measuring arrangement may be arranged to determine if the cooling medium surface has exceeded the fluid overflow level of the chamber. If the cooling medium surface has exceeded the fluid overflow level, this means that the remaining volume of the chamber is not sufficient to house the fluid volume and a non-zero air volume, and accordingly, the cooling medium will push at least a portion of the fluid volume out of the chamber. Hence, the cooling medium level measuring arrangement may be arranged to, if so, issue a signal indicating the need for a replenish of fluid to the expansion vessel to restore the fluid volume.

This situation may occur during exceptional events in the cooling system, resulting in an expansion of the cooling medium being greater than the envisaged expansion volume. During normal operation of the cooling system, the fluid volume in the chamber should as mentioned in the above remain constant and not require replenish.

Optionally, the cooling medium level measuring arrangement may arranged to determine if the cooling medium surface has exceeded the maximum cooling medium level of the chamber, and, if so, issuing a signal indicating the need for a replenish of fluid to the expansion vessel to restore the fluid volume. This may be used to indicate any exceptional event in the cooling system which may result in a need for replenish of fluid.

The provision of a cooling medium level measuring arrangement and the issuance of a signal indicating the need for a replenish of fluid is optional and considered to be useful to warn if exceptional events should occur in the cooling system.

Without exceptional events, the fluid volume should remain substantially constant in the chamber. However, due to that some slow leakage of the fluid volume may nevertheless occur over time, it is envisaged that the fluid volume may be controlled and if required replenished in a maintenance procedure for the cooling system. It is envisaged that such maintenance could take place for example after 2-3 years of operation of the expansion vessel.

If fluid is pushed out of the chamber, it may for example exit via the air intake.

Optionally, the chamber may comprise a fluid overflow conduit for outlet of the fluid, the fluid overflow conduit being connected to a fluid assembly unit, for example the fluid assembly unit is a fluid supply. In this way, any fluid exiting the chamber may be assembled, to prevent leakage of fluid to the atmosphere.

In a second aspect there is provided a method for hindering corrosion in an expansion vessel in a cooling system using a cooling medium comprising water; wherein the expansion vessel forms a chamber having an extension in a vertical direction, and being arranged to, during normal operation of the cooling system be open to atmospheric air ambient of the chamber; and the chamber being adapted to comprise a cooling medium volume of the cooling medium, the cooling medium volume filling the chamber up to a cooling medium surface which is located between a minimum cooling medium level and a maximum cooling medium level of the chamber, the method comprising:
introducing a volume of fluid in the chamber, the fluid having a density between the density of the cooling medium and the atmospheric air,
so as to form a fluid volume in the chamber being selected such that, for each vertical location of the cooling medium surface between the minimum cooling medium level and maximum cooling medium level, a thickness of the fluid volume from the cooling medium surface to a fluid volume upper surface is sufficient to hinder the atmospheric air from being dissolved in the cooling medium via the gas volume.

The method may be performed during initial set up of the cooling system before starting operation of the cooling system.

Optionally, the method is performed after a period of operation of the cooling system. For example, the method may be performed upon receipt of a signal that the fluid volume may require replenish.

Optionally, the method may be performed manually.

In another option, the method may be controlled e.g. by a control unit controlling the amount of fluid to be replenished to the chamber. Optionally, such a control unit may be connected to a cooling medium measuring arrangement as described in the above.

In a third aspect, the invention comprises a method for issuing a signal to replenish a fluid layer in an expansion vessel in accordance to the first aspect, the method comprising:
determining the vertical location of a present cooling medium surface in the chamber;
comparing the location of the present cooling medium surface with a fluid overflow level of the chamber; and
If the location of the present cooling medium surface is greater than or equal to the fluid overflow level,
Issuing a signal indicating a need to replenish the fluid volume.

Optionally, the method may further comprise, before the step of issuing a signal indicating a need to replenish the fluid volume; determining that the vertical location of a present cooling medium surface has been restored to a level below the fluid overflow level. As such, it is ensured that the cooling medium surface is restored to a level such that there is room in the chamber for the required fluid volume.

The fluid overflow level is equal to or greater than the maximum cooling medium level.

Optionally, the method may comprise determining that the vertical location of a present cooling medium surface has been restored to a level below the fluid overflow level which is also below the maximum cooling medium level. Accordingly, it is ensured that the vessel is back to normal operation before the fluid is replenished.

Optionally, the chamber may be connected to a fluid supply and the method further comprises: Initiating replenish of fluid to the chamber (100) from the fluid supply (600).

In a fourth aspect, there is provided a cooling system using cooling medium comprising water, the cooling system comprising an expansion vessel forming a chamber adapted to, in use be open to atmospheric pressure, the chamber comprising at least one air conduit for inlet and/or outlet of air at atmospheric pressure, at least one cooling medium conduit for inlet and/or outlet of cooling medium, and at least one fluid conduit being in connection with a fluid supply for supply of a fluid having a density greater than the density of the cooling medium and less than the density of the air to the chamber.

Optionally, the expansion vessel comprises a cooling medium level measuring arrangement for determining a vertical location of a cooling medium surface in the chamber; and being arranged to, when the cooling system is in operation, determine if the cooling medium surface has exceeded a fluid overflow level of the chamber, and, if so, initiate replenishing of the chamber with fluid from the fluid supply.

In a fifth aspect, there is provided a cooling system adapted for a cooling medium comprising water, the cooling system comprising an expansion vessel,
the expansion vessel forming a chamber being open to atmospheric pressure and being adapted to define
a minimum cooling medium level and a maximum cooling medium level for a cooling medium surface in the chamber, wherein the volume in the chamber between the minimum cooling medium level and maximum cooling medium level is equal to a cooling medium expansion volume of the cooling system;
and a volume above the maximum cooling medium level in the chamber is equal to or greater than a fluid volume, wherein the fluid volume is selected such that, for each cooling medium surface between the minimum cooling medium level and the maximum cooling medium level, the fluid volume from the medium surface to a fluid volume upper surface is sufficient to hinder the atmospheric air from being dissolved in the cooling medium via the gas volume.

As used herein, the cooling medium expansion volume of a cooling system, is the volume variation of the cooling medium expected during normal operation of the cooling system.

It will be understood that the different aspects of the disclosure as described herein may advantageously be combined. Features and functions described in relation to one aspect, are equally applicable to the other aspects described herein.

### BRIEF DESCRIPTION OF THE DRAWINGS

The present invention will now be described more fully hereinafter with reference to the accompanying drawings showing variants of the invention.
Fig. 1 shows a cross-section of a schematically illustrated expansion vessel for a cooling system according to a first variant of the present invention.
Fig. 2 shows a cross-section of a schematically illustrated expansion vessel for a cooling system according to a second variant of the present invention.
Fig. 3 shows a cross-section of a schematically illustrated expansion vessel for a cooling system according to another variant of the present invention.
Fig. 4 shows an example of a cooling system comprising an expansion vessel according to a variant of the present invention.

Similar reference numbers indicate similar features throughout the drawings, unless otherwise indicated.

### DETAILED DESCRIPTION

The present disclosure relates to an expansion vessel for a cooling system using a cooling medium comprising water. The expansion vessel comprises a chamber which is open to atmospheric air ambient of the chamber. The present disclosure also relates to cooling systems comprising water as a cooling medium and comprising an expansion vessel as disclosed herein. Cooling systems are used in many applications for cooling components which generate heat and for cooling components which may be sensitive to heat.

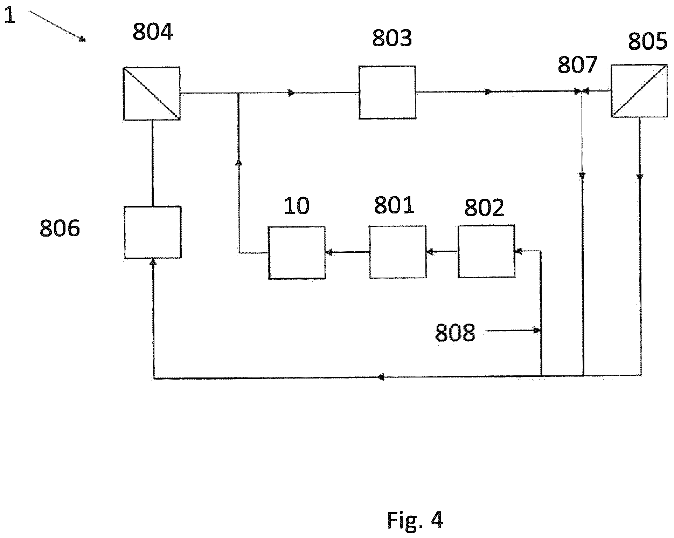

In Fig. 4 an example of a cooling system 1 is shown in an illustrative scheme. This is an illustrative example of a cooling system 1 where an expansion vessel 10 as described herein may be used and application in numerous other cooling systems are possible. The expansion vessel 10 has a chamber which has space for regulating for the expansion and reduction of the volume of the cooling medium of the cooling system 1 during operation. The expansion vessel 10 is open to atmospheric air.

The cooling system 1 comprises a cooling medium comprising water. The water may be deionized water to not be conducting in the system. An expansion vessel 10 as disclosed herein is arranged in the cooling system 1, which expansion vessel 10 is open to atmospheric air ambient the expansion vessel 10. The water in the cooling system 1 is filtered by a mechanical filter 801 to avoid dust or particles, and the water is continuously purified from ions and oxygen. An ion exchanger 802 and a filter 801 are arranged before the expansion vessel 10 in the flow direction. A pump 803 is arranged to circulate the cooling water for an effective cooling and for circulating water to the object 804 to be cooled. The pump 803 is coupled to the expansion vessel 800 after the expansion vessel 800 in order to secure that air is not entering the pump 803. The object 804 to be cooled is coupled into the system 1 and the warm water, where the energy is received from the object 804 which is cooled, is pumped in the system 1 and reaches a heat exchanger 805 to cool the water. A strainer 806 may be arranged in the system 1 and is a mechanical filter for the main cooling water. If it is required to keep the cooling medium at a desired temperature a bypass 807 can be arranged in the system 1. With an inlet 808 for cooling medium there is a possibility to fill up cooling medium when necessary. This can be made automatically or manually.

### Expansion vessel

The expansion vessel 10 handles the volume variation of the cooling medium which is due to temperature variations. The expansion vessel 10 is open to atmosphere and may include a ventilation dual direction valve in the upper part of the vessel, through which the air can be entering or exiting, depending on if water from the system 1 is entering or exiting the expansion vessel 10. To protect the cooling system 1 from corrosion, a fluid volume of a fluid which protects the cooling medium from air is comprised in the expansion vessel 10. The fluid may be an inert gas. The expansion vessel 10 open to atmosphere is arranged on a level above the level of the cooling system.

### Filter

A fine filter may be used in the cooling system for avoiding that small particles are circulated in the system.

### Ion exchanger

Deionization of the water may be used for purifying the system from ions. The conductivity of the water can be kept as low as <0.1µS/cm (at 25°). An example of an ion exchanger may be an enclosure containing a chemical resin that deionizes the water to a defined level.

The filter 801 and the ion exchanger 802 may be considered to be comprised in a purifying part of the cooling system.

### Pump

A pump 803 may be used for an effective cooling and for circulating the cooling medium to the object 804 to be cooled. Air in the pump 803 may create cavitation which would negatively influence the circulation of the cooling water. Therefore, the pump 803 may be coupled directly after the expansion vessel 10. Further, the expansion vessel 10 cannot be empty on water, because air will then enter the pump 803.

### Heat exchanger

The heat exchanger 805 may for example be a liquid to liquid cooling exchanger, a liquid to air cooling exchanger or based on two phase evaporation technology.

### Object to be cooled

Cooling systems utilizing a cooling medium comprising water, such as for example pure water cooing systems may be used to cool numerous different objects.

Examples of objects to be cooled are semiconductor valves for HVDC (High Voltage Direct Current) and SVC (Static Var compensation) applications, converters, rectifiers, stirrers, generators, etc. Further examples are nuclear power, wind power, HVDC (High Voltage Direct Current) and SVC (Static Var compensation) projects, industries, non-electrical environment, medical and research applications.

The cooling systems may be installed in all types of environments, such as indoor and outdoor environment, offshore and onshore.

As mentioned above, the cooling system described in Fig. 4 is only an example of a cooling system for which the expansion vessels and methods described herein may be used. The disclosure may be applied to other cooling systems, containing additional components or less components.

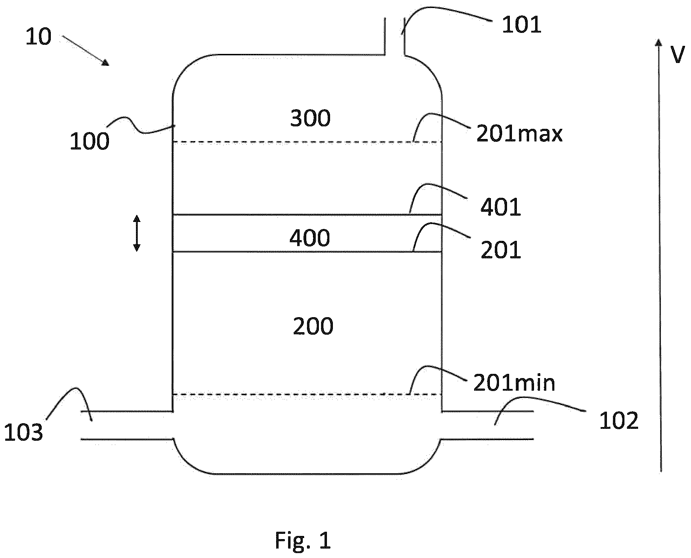

In Fig. 1 an expansion vessel 10 according to a first variant of the disclosure is illustrated. The expansion vessel 10 is to be used in a cooling system using a cooling medium comprising water. The expansion vessel 10 forms a chamber 100 having an extension in a vertical direction V, and, during normal operation of the cooling system, the chamber 100 is open to atmospheric air ambient of the chamber. The expansion vessel 10 comprises a cooling medium volume 200 of the cooling medium, the cooling medium volume 200 filling the chamber 100 up to a cooling medium surface 201 which is located between a minimum cooling medium level 201min and a maximum cooling medium level 201max in the chamber 100. The chamber 100 further comprises a fluid volume 400 of a fluid having a density between the density of the cooling medium and the atmospheric air. The fluid volume 400 is filling the chamber 100 from the cooling medium surface 201 to a fluid volume upper surface 401, wherein the fluid volume 400 is selected such that, for each location of the cooling medium surface 201 between the minimum cooling medium level 201min and maximum cooling medium level 201max, a thickness of the fluid volume 400 from the cooling medium surface 201 to the fluid volume upper surface 401 is sufficient to hinder the atmospheric air from being dissolved in the cooling medium via the fluid volume 400. The chamber 100 further comprises a non-zero air volume 300 of atmospheric air, the air volume 300 filling the remainder of the chamber 100 vertically above the fluid volume upper surface 401.

The purpose with the fluid volume 400 is to hinder the air from contacting the water of the cooling medium. If air comes into contact with the water, oxygen from the air will be dissolved in the water. Oxygen may be dissolved in water e.g by transfer of oxygen across an air-water interface. The oxygen dissolved in water causes corrosion..

The fluid which is comprised in the expansion vessel 10 has a density between the density of the cooling medium and air and will form a gas layer between the water in the cooling medium volume 200 and the air in the air volume 300. The air and thus the oxygen will then be hindered from contact with the water. This then means that oxygen from the air will not be dissolved into the water.

For determining the thickness of the fluid volume 400, it is sufficient to theoretically use the fluid volume filled into the chamber 100, and to assume that the fluid volume starts at the location of the cooling medium surface 201. Thus, the vertical location of the upper fluid surface 401 may be theoretically calculated rather than practically determined.

By "open to atmospheric air" is meant that the atmospheric air outside the expansion vessel 10 has access to the expansion vessel 10 and the pressure in the vessel is atmospheric. The air has access to the expansion vessel 10 via an opening. The opening may be a for example an air conduit 101 and the air conduit 101 may comprise a valve. The valve may be a dual direction valve. The expansion vessel 10 may further be a vessel which is completely open at the top of the vessel. In this case, a separate lid can be arranged on top of the vessel but with air access to the expansion vessel 10. A roof or upper cover is not necessarily needed for the expansion vessel but it if the vessel is located outdoors it is preferred to have a roof in order to hinder rain or dirt to enter the expansion vessel 10.

By the opening in the expansion vessel 10 the air in the vessel may also exit from the expansion vessel 10. When the cooling liquid in the cooling system expands, the cooling medium surface 201 will move upwards as well as the fluid volume surface 401and air will be forced to exit from the expansion vessel 10. Further, when the volume 200 of the cooling liquid in the cooling system decreases, air is in the opposite direction entering the expansion vessel 10, the cooling medium surface 201 is lowered, and the fluid volume surface 401 is lowered. When the chamber 100 comprises an air conduit 101 the chamber 100 may comprise at least one air conduit 101 for inlet and/or outlet of air at atmospheric pressure. The air conduit 101 may be arranged at or adjacent the top end of the chamber. Further, the air conduit 101 may comprise a dual direction valve. The air conduit 101 may also comprise a filter for hindering dirt and dust to enter the expansion vessel 10.

The fluid may be a fluid being insoluble in the cooling medium or the fluid may be soluble in the cooling medium without forming ions. The fluid should be an inert fluid which will form a layer on top of the cooling medium volume 200.

The preferred fluid is gas. Advantageously, the gas may be a noble gas. For example, the gas may be selected from argon, xenon and krypton.

Alternative heavy gases may be greenhouse gases or fluorinated gases such as hydrofluorocarbon gases or perfluorcarbons gases.

The expansion vessel is open to atmospheric air but the chamber 100 of the expansion vessel 10 is preferably protected from the environment. Therefore, the fluid volume 400 is not affected by the environment, such as winds for example, but will remain in the chamber 100 at a substantially constant fluid volume 400 during normal operation of the vessel 10 in the cooling system.

The fluid volume 400 may be selected such that the thickness of the fluid volume 400 in the chamber is at least 2 cm, preferably at least 3 cm and most preferred at least 5 cm. This is valid for each location of the cooling medium surface 201. It will be understood that the cooling medium surface 201 will move vertically when the cooling medium volume 200 is expanding or is being reduced during operation of the vessel 10. The cooling medium surface 201 will move between the minimum cooling medium level 201min and the maximum cooling medium level 201max. If the chamber 100 has a regular cross-section perpendicular to the vertical direction V, the thickness of the fluid volume 400 will be the same for all vertical locations of the cooling medium surface 201. However, if the cross-section of the chamber 100, perpendicular to the vertical direction, is not regular, the thickness of the fluid volume 400 will vary between different locations of the cooling medium surface 201 in the vessel.

The thicker fluid layer the better the hindrance of air to reach the cooling medium surface 201. However, with a thin layer it would be less expensive since less fluid would be used.

A smaller vessel may need a thinner layer of fluid, as the surface coverage is maintained, as the variation over the surface is less.

The fluid volume 400 may be selected such that the thickness of the fluid volume 400, for each location of the cooling medium surface 201 in the chamber 100 is less than 50 cm, preferably less than 15 cm, preferred less than 10 cm. A thickness of the fluid volume which is effective for hindering air and oxygen to reach the cooling medium surface 201 will be achieved and at the same time a cost effective cooling system will be achieved since thickness of the volume of the fluid volume 400 may not be higher than necessary..

The cooling medium may be tap water or deionized water. The tap water or the deionized water may comprise an anti-freeze agent. The anti-freeze agent may be glycol. The addition of an anti-freeze agent is preferred in case the cooling system is located in an environment where the temperature will sometimes be below the freezing temperature of water.

The chamber 100 may comprise at least one cooling medium conduit 102, 103 for inlet and/or outlet of cooling medium. The cooling medium conduit 102, 103 may be arranged at the bottom end of the chamber 100 or adjacent the bottom end of the chamber. By an arrangement of the cooling medium conduit 102, 103 in the bottom of the chamber any risk of movement of cooling medium surface 201 will be reduced when the cooling medium is entering the chamber.

When, as in the variant illustrated in Fig. 1, the expansion vessel uses two cooling medium conduits 102, 103 for inlet and outlet, respectively, of the cooling medium there is circulation of the water in the expansion vessel. This is often used for HVDC where it is desired to avoid that ions are contained in the water. Standing water may create ions.

In the variant of Fig. 1, the air conduit 101 is arranged vertically above the cooling medium conduit 102, 103.

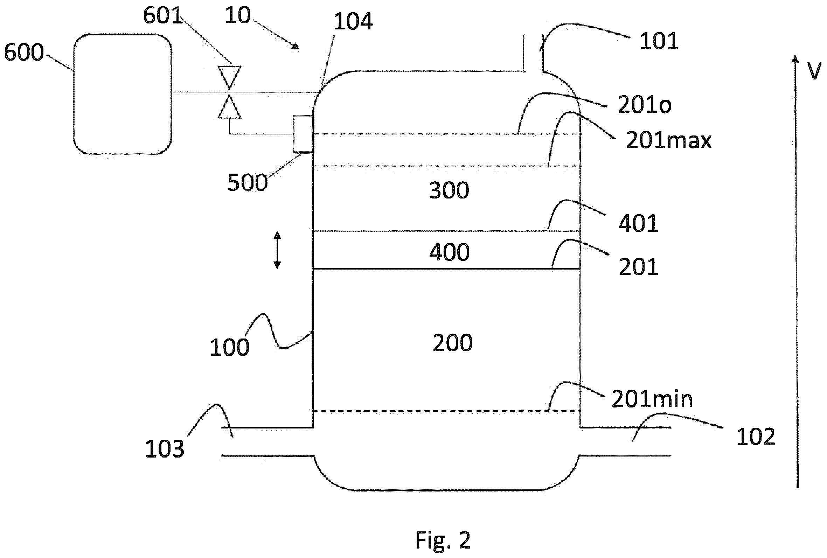

Another example of an expansion vessel according to the disclosure is shown in Fig. 2. The expansion vessel in Fig. 2 is generally similar to the expansion vessel in Fig. 1 and the description of features which are similar will not be repeated here. The expansion vessel 10 may comprise a fluid conduit 104 for inlet/outlet of the fluid.

As described in the above, during normal operation of the expansion vessel 10, the fluid volume 400 is substantially constant and need not be replenished.

However, upon exceptional circumstances in the cooling system 1, the chamber 100 may nevertheless need to be replenished with fluid. For example, there may be an overflow in the expansion vessel 10 if the cooling medium volume 200 is expanding, i.e. when cooling medium is entering the chamber 100 in such an amount so that the cooling medium surface 201 will rise to a level higher than the maximum cooling medium level 201max. For example, the cooling medium surface 201 may reach a level in the chamber 100 being so high that the fluid volume 400 and its fluid volume upper surface 401 will reach the top of the chamber 100, meaning that at least a part of the fluid volume 400 will exit from the chamber 100 via the air conduit 101 or the fluid conduit 104.

As illustrated in Fig. 2, the expansion vessel 10 may comprise a cooling medium level measuring arrangement 500 for determining the vertical location of the cooling medium surface 201 in the chamber 100. When the cooling medium is expanding or is reduced in volume, the cooling medium surface 201 will move upwards or downwards. If the expansion of the cooling medium leads to an overflow, i.e. the fluid will exit the expansion vessel via the air conduit 101 or the fluid conduit 104, a signal will be transmitted for replenishing of fluid. Fluid may be replenished after that the cooling medium surface 201 has been re-established to a level below the maximum cooling medium level 201max. Optionally, if the cooling medium is expanded in volume so much that also cooling medium exits the chamber 100, a signal may be transmitted for refilling of cooling medium.

The chamber 100 may have a fluid overflow level 201o which is defined as the vertical level in the chamber 100 above which the volume of the chamber 100 is equal to the fluid volume 400. The chamber volume above the fluid overflow level 201o is equal to the fluid volume 400. If the cooling medium volume 200 in the chamber 100 is so large that the cooling medium surface 201 reaches above the fluid overflow level 20o of the chamber the fluid volume 400 will overflow. The cooling medium level measuring arrangement 500 may be arranged to determine if the cooling medium surface 201 has exceeded the fluid overflow level 201o of the chamber. If the fluid overflow level 201o has been exceeded, a signal may be issued for indicating the need for replenish of fluid to the expansion vessel 100 to restore the fluid volume 400. The situation when there is an overflow of cooling medium is under exceptional circumstances. Under normal operation of the cooling system no overflow is expected to occur.

The cooling medium level measuring arrangement 500 may alternatively or additionally be arranged to determine if the cooling medium surface 201 has exceeded the maximum cooling medium level 201max of the chamber. If it has, a signal may be issued indicating the need for a replenish of fluid to the expansion vessel 10 to restore the fluid volume 400. This may be either an indication to that the fluid volume 400 may need to be replenished or if the maximum cooling medium level is set at a high level of the chamber 100 there may be an overflow of fluid and fluid need to be replenished.

The cooling medium level measuring arrangement 500 may be arranged to perform the determination with any suitable determining methods, such as using level sensors, radar etc.

As mentioned in the above, the measurement arrangement 500 is optional. If a measurement arrangement 500 is not used, replenishment of the fluid may be performed during maintenance. A visible cooling medium surface level indicator e.g. for manual inspection can be a glass tube arranged on the outside of the expansion vessel in fluid connection with the expansion vessel, where the cooling medium surface level can be seen.

Further, as exemplified in Fig. 1, the expansion vessel may be connected to a fluid supply 600. The fluid supply 600 will comprise the fluid to be used for replenishing of fluid e.g. when such a signal is issued. The fluid supply 600 may be connected to the expansion vessel 10 via one or more valves 601. For example, when the measurement arrangement 500 indicates that the cooling medium surface 201 has exceeded the fluid overflow level 201o, a valve 601 may be opened to replenish fluid from the fluid supply 600. However, before the replenishing, it may be determined that the vertical location of a present cooling medium surface 201 has been restored to a level below the fluid overflow level 201o.

The present disclosure further relates to a method for hindering corrosion in a cooling system 1 using a cooling medium comprising water. The expansion vessel 10 forms a chamber 100 having an extension in a vertical direction V, and being arranged to, during normal operation of the cooling system 1 be open to atmospheric air ambient of the chamber; and the chamber 100 being adapted to comprise a cooling medium volume 200 of the cooling medium, the cooling medium volume 200 filling the chamber 100 up to a cooling medium surface 201 which is located between a minimum cooling medium level 201min and a maximum cooling medium level 201max of the chamber 100. The method comprises:
introducing a volume of fluid in the chamber 100, the fluid having a density between the density of the cooling medium and the atmospheric air,
so as to form a fluid volume 400 in the chamber 100 being selected such that, for each vertical location of the cooling medium surface 201 between the minimum cooling medium level 201min and maximum cooling medium level 201max, a thickness of the fluid volume 400 from the cooling medium surface 201 to a fluid volume upper surface 401 is sufficient to hinder the atmospheric air from being dissolved in the cooling medium via the gas volume.

The method may be performed during an initial set up of the cooling system 1 before starting the operation of the cooling system 1. An existing cooling system using expansion vessels open to atmospheric air may be used and a volume of the fluid may be filled into the expansion vessel via an opening. The fluid may be filled via a refill opening or via the air conduit 101.

The method may also be performed after a period of operation of the cooling system 1. It could for example be upon receipt of a signal that the fluid volume 400 may require replenish.

It is envisaged that even if no exceptional events causing fluid overflow in the system should occur, the fluid volume may advantageously be controlled and if necessary replenished during regular maintenance of the cooling system, which may be performed e.g. every 2 to 3 years.

The present disclosure also relates to a method for issuing a signal to replenish a fluid layer in an expansion vessel 10 as disclosed herein. The method comprises:
determining the vertical location of a present cooling medium surface 201 in the chamber 100;
comparing the location of the present cooling medium surface 201 with a fluid overflow level 201o of the chamber 100; and
if the location of the present cooling medium surface 201 is greater than or equal to the fluid overflow level 201o,
issuing a signal indicating a need to replenish the fluid volume 400.

Optionally, before the step of issuing a signal indicating a need to replenish the fluid volume 400, the method comprises determining that the vertical location of a present cooling medium surface 201 has been restored to a level below the fluid overflow level 201o. Then there will be enough space for replenishing the fluid to the expansion vessel.

The method may further comprise that the chamber 100 is connected to a fluid supply 600 and the method further comprises:
initiating a replenish of fluid to the chamber 100 form the fluid supply 600.

The fluid overflow level 201o is equal to or greater than the maximum cooling medium level 201max. When the maximum cooling medium level 201 reaches the fluid overflow level 201o there will be an overflow of fluid.

The present disclosure also relates to a cooling system 1 using cooling medium comprising water, the cooling system 1 comprising an expansion vessel 10 forming a chamber 100 adapted to, in use, be open to atmospheric pressure, the chamber 100 comprising at least one air conduit 101 for inlet and/or outlet of air at atmospheric pressure, at least one cooling medium conduit 102, 103 for inlet and/or outlet of cooling medium, and at least one fluid conduit 104 being in connection with a fluid supply 600 for supply of a fluid having a density greater than the cooling medium and less than air to the chamber 100.

The disclosure further relates to a cooling system 1, wherein the expansion vessel 10 comprises a cooling medium level measuring arrangement 500 for determining a vertical location of a cooling medium surface 201 in the chamber 100; and being arranged to, when the cooling system 1 is in operation, determine if the cooling medium surface 201 has exceeded a fluid overflow level 201o of the chamber, and, if so, initiate replenishing of the chamber 100 with fluid from the fluid supply 600.

The present disclosure also relates to a cooling system 1 adapted for a cooling medium comprising water, the cooling system 1 comprising an expansion vessel 10. The expansion vessel forms a chamber 100 which is open to atmospheric pressure and is adapted to define a minimum cooling medium level 201min and a maximum cooling medium level 201max for a cooling medium surface 201 in the chamber 100. The volume in the chamber 100 between the minimum cooling medium level (201min) and the maximum cooling medium level 201max is equal to a cooling medium expansion volume of the cooling system 1; and a volume above the maximum cooling medium level 201max in the chamber 100 is equal to or greater than a fluid volume 400, wherein the fluid volume 400 is selected such that, for each cooling medium surface 201 between the minimum cooling medium level 201min and maximum cooling medium level 201max, the fluid volume 400 from the medium surface 201 to a fluid volume upper surface 401 is sufficient to hinder the atmospheric air from being dissolved in the cooling medium via the gas volume.

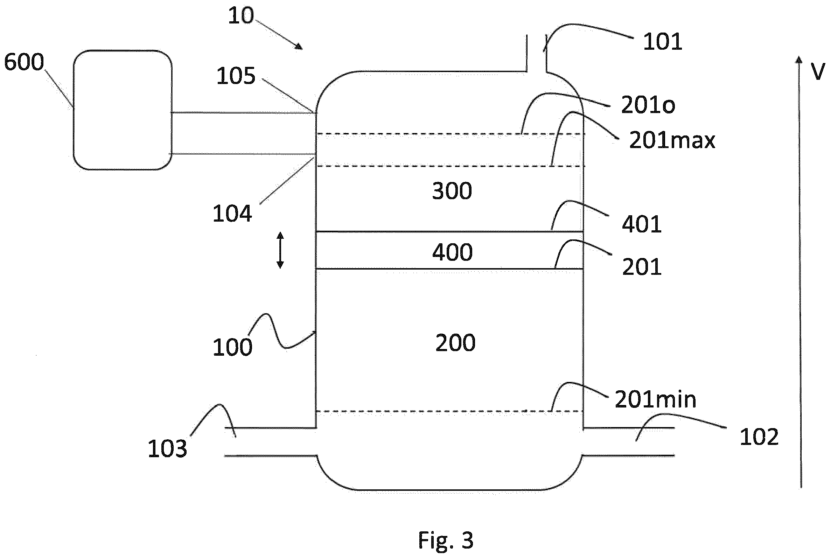

Another example of an expansion vessel according to the disclosure is shown in Fig. 3. The expansion vessel in Fig. 3 is generally similar to the expansion vessel in Fig. 1 and Fig. 2 and the description of similar features will not be repeated here.

The chamber 100 may comprise a fluid overflow conduit 105 for outlet of the fluid, the fluid overflow conduit 105 is connected to a fluid assembly unit. The fluid assembly unit may be a fluid supply 600. When the fluid volume 400 is raised to the level of the overflow conduit 105 some fluid may flow to the fluid supply unit 600. The overflown fluid may possibly be reused later for replenishing of fluid. Optionally, the fluid overflow conduit 105 may instead be connected to a fluid assembly unit for assembling the fluid for later reuse. Thus, it may be ensured that fluid does not leak out from the expansion vessel 10, to the benefit of environment and economy.

It will be understood that numerous alternatives of the vessels, systems and methods described herein are available.

It will be understood that the methods disclosed herein may be implemented by a control unit, e.g. a control unit connected to a measurement arrangement as described in the above for controlling the vessels and/or cooling systems.

## Claims

1. An expansion vessel (10) for a cooling system (1) using a cooling medium comprising water, said expansion vessel (10) forming a chamber (100) having an extension in a vertical direction (V), and, during normal operation of said cooling system (1), said chamber (100) is open to atmospheric air ambient of said chamber and comprises
- a cooling medium volume (200) of said cooling medium, said cooling medium volume (200) filling said chamber (100) up to a cooling medium surface (201) which is located between a minimum cooling medium level (201min) and a maximum cooling medium level (201max) in said chamber (100);
- a fluid volume (400) of a fluid having a density between the density of said cooling medium and the density of said atmospheric air;
said fluid volume (400) filling said chamber (100) from said cooling medium surface (201) to a fluid volume upper surface (401), wherein said fluid volume (400) is selected such that, for each location of said cooling medium surface (201) between said minimum cooling medium level (201min) and maximum cooling medium level (201max), a thickness of said fluid volume (400) from said cooling medium surface (201) to said fluid volume upper surface (401) is sufficient to hinder said atmospheric air from being dissolved in said cooling medium via said fluid volume (400); and
- a non-zero air volume (300) of atmospheric air, said air volume (300) filling the remainder of said chamber (100) vertically above said fluid volume upper surface (401).

2. An expansion vessel according to claim 1, wherein said fluid is a fluid being insoluble in said cooling medium or said fluid being soluble in said cooling medium without forming ions.

3. An expansion vessel (10) according to any one of the preceding claims, wherein said fluid is a gas, preferably a noble gas, for example said gas is argon, xenon or krypton.

4. An expansion vessel (10) according to any one of the preceding claims, wherein said fluid volume (400) is selected such that said thickness of said fluid volume (400), for each location of said cooling medium surface (201) in said chamber (100) is at least 2 cm, preferably at least 3 cm, most preferred at least 5 cm.

5. An expansion vessel (10) according to any one of the preceding claims, wherein said fluid volume (400) is selected such that said thickness of said fluid volume (400), for each location of said cooling medium surface (201) in said chamber (100) is less than 50 cm, preferably less than 15 cm, most preferred less than 10 cm.

6. An expansion vessel (10), wherein said cooling medium is tap water or deionized water, preferably comprising anti-freeze agent.

7. An expansion vessel (10) according to any one of the previous claims, wherein said chamber comprises at least one air conduit (101) for inlet and/or outlet of air at atmospheric pressure and/or,
wherein said chamber (100) comprises at least one cooling medium conduit (102, 103) for inlet and/or outlet of cooling medium.

8. An expansion vessel (10) according to any one of the previous claims, wherein said chamber (100) comprises a fluid conduit (104) for inlet/outlet of said fluid.

9. An expansion vessel (10) according to any one of the previous claims wherein said expansion vessel comprises a cooling medium level measuring arrangement (500) for determining the vertical location of said cooling medium surface (201) surface in said chamber (100), and
wherein preferably a fluid overflow level (201o) in said chamber (100) is defined as the vertical level in said chamber (100) above which the volume of said chamber (100) is equal to said fluid volume (400) ; and
said cooling medium level measuring arrangement (500) is arranged to determine if said cooling medium surface (201) has exceeded said fluid overflow level of said chamber (100), and, if so, issue a signal indicating the need for a replenish of fluid to said expansion vessel (100) to restore said fluid volume (400).

10. An expansion vessel (10) according to any one of the previous claims, wherein said chamber comprises a fluid overflow conduit (105) for outlet of said fluid, said fluid overflow conduit (105) being connected to a fluid assembly unit, for example said fluid assembly unit is a fluid supply (600).

11. Method for hindering corrosion in an expansion vessel in a cooling system using a cooling medium comprising water; wherein the expansion vessel (10) forms a chamber (100) having an extension in a vertical direction (V), and being arranged to, during normal operation of said cooling system (1) be open to atmospheric air ambient of said chamber; and said chamber (100) being adapted to comprise a cooling medium volume (200) of said cooling medium, said cooling medium volume (200) filling said chamber (100) up to a cooling medium surface (201) which is located between a minimum cooling medium level (201min) and a maximum cooling medium level (201max) of said chamber (100), the method comprising:
- introducing a volume of fluid in said chamber (100), said fluid having a density between the density of said cooling medium and the atmospheric air,
so as to form a fluid volume (400) in said chamber (100) being selected such that, for each vertical location of said cooling medium surface (201) between said minimum cooling medium level (201min) and maximum cooling medium level (201max), a thickness of said fluid volume (400) from said cooling medium surface (201) to a fluid volume upper surface (401) is sufficient to hinder said atmospheric air from being dissolved in said cooling medium via said gas volume (400).

12. Method according to claim 11, wherein said method is performed during initial set up of the cooling system (1) before starting operation of said cooling system (1), and/or
wherein said method is performed after a period of operation of said cooling system (1), for example upon receipt of a signal that the fluid volume (400) may require replenish.

13. Method for issuing a signal to replenish a fluid layer in an expansion vessel according to claim 1:
comprising:
- determining the vertical location of a present cooling medium surface (201) in said chamber (100);
- comparing the location of said present cooling medium surface (201) with a fluid overflow level (201o) of said chamber (100); and
- if said location of said present cooling medium surface (201) is greater than or equal to said fluid overflow level (201o),
- issuing a signal indicating a need to replenish said fluid volume (400).

14. Method according to claim 13, further comprising, before said step of issuing a signal indicating a need to replenish said fluid volume (400);
- determining that the vertical location of a present cooling medium surface (201) has been restored to a level below said fluid overflow level (201o).

15. Method according to claim 13, wherein said chamber (100) is connected to a fluid supply (600) and said method further comprises
- initiating replenish of fluid to said chamber (100) from said fluid supply (600).

16. Cooling system (1) using cooling medium comprising water, said cooling system (1) comprising an expansion vessel (10) forming a chamber (100) adapted to, in use be open to atmospheric pressure, said chamber (100) comprising at least one air conduit (101) for inlet and/or outlet of air at atmospheric pressure, at least one cooling medium conduit (102, 103) for inlet and/or outlet of cooling medium, and at least one fluid conduit being in connection with a fluid supply (600) for supply of a fluid having a density greater than the density of said cooling medium and less than the density of air to said chamber (100).
